# FASCICULE DE BREVET EUROPEEN

(11) **EP 3 613 076 B1**
(45) Date de publication et mention de la délivrance du brevet: **24.02.2021**
(21) Numéro de dépôt: 18719984.9
(22) Date de dépôt: 16.04.2018
(51) Int. Cl.: H01L 23/66, H01L 25/065, H01L 23/49, H04B 1/00, H04B 5/00, G06K 19/077, H01Q 1/22, H01Q 5/30, H01Q 5/321, H01Q 5/35, H01Q 7/00, H01Q 9/20

(54) **DISPOSITIF D'EMISSION RECEPTION RADIOFREQUENCE**
HOCHFREQUENZ SENDE- UND EMPFANGSVORRICHTUNG
RADIOFREQUENCY TRANSMISSION/RECEPTION DEVICE

(30) Priorité: 19.04.2017 FR 1753405
(43) Date de publication de la demande: 26.02.2020
(73) Titulaire: PRIMO1D, 38040 Grenoble Cedex 9 (FR)
(72) Inventeur: ANDIA VERA, Gianfranco, 13013, Chateau Gombert Marseille (FR); ARENE, Emmanuel, 38330 Biviers (FR)
(74) Mandataire: IP Trust
(86) Numéro de dépôt international: PCT/FR2018/050956
(87) Numéro de publication internationale: WO 2018/193199

(56) Documents cités:
- EP-A1- 1 630 728
- EP-A1- 3 319 168
- FR-A1- 2 917 895
- FR-A1- 2 937 464
- US-A1- 2011 068 987
- US-A1- 2012 258 660
- US-A1- 2014 117 927
- US-B2- 8 471 773

## Description

### DOMAINE DE L'INVENTION

La présente invention concerne un dispositif d'émission-réception radiofréquence.

### ARRIERE PLAN TECHNOLOGIQUE DE L'INVENTION

On connaît des documents US8471773 et FR2917895 un exemple d'un tel dispositif qui peut trouver son application dans le domaine de l'étiquetage électronique RFID (pour « Radio Frequency Identification » selon la terminologie anglo-saxonne). Il comprend une puce et un dispositif de couplage, souvent désigné par le terme « antenne », de la puce à un champ électromagnétique permettant de communiquer avec un terminal d'émission-réception. Le premier document précité rappelle que selon la fréquence de transmission utilisée entre le terminal d'émission-réception et le dispositif radiofréquence, l'antenne de ce dispositif est configurée pour former soit une boucle (pour des fréquences de transmission comprises entre quelques centaines de kilohertz et quelques mégahertz), soit configurée pour former un dipôle (pour des fréquences de transmission comprises entre quelques mégahertz et quelques gigahertz).

Dans le premier type de dispositif RF, présentant une plage de fonctionnement à relativement basse fréquence, la communication entre le terminal et le dispositif RF n'est possible qu'à très courte distance. Un signal est induit dans le dispositif de couplage sans que celui-ci ne forme à proprement parler une antenne (et bien qu'il soit d'usage de désigner par « antenne » ce dispositif de couplage). Le dispositif de couplage peut prendre la forme d'une boucle. Dans ce cas, en mode réception, le signal peut se développer par couplage magnétique. Dans d'autres configurations du dispositif RF, le dispositif de couplage prend la forme d'une simple ligne de transmission et le signal se développe par couplage électrique avec une ligne de transmission de l'émetteur, placé à proximité. Quelle que soit la forme, électrique ou magnétique, que prend le couplage entre l'émetteur et l'antenne, la puce d'émission-réception est configurée pour fonctionner « en champ proche ». Elle comprend un circuit de modulation, un circuit de démodulation et un circuit d'alimentation électrique, associés à l'antenne et configurés pour rendre la puce d'émission-réception active dans la plage de fonctionnement en fréquence relativement basse.

Le second type de dispositif RF, présentant une plage de fonctionnement à plus haute fréquence, est généralement utilisé pour des applications dans le domaine de la logistique, pour identifier, compter, suivre des objets. Le dispositif de couplage est constitué d'une antenne en dipôle dont la longueur est ajustée à la fréquence d'émission du terminal d'émission-réception et entrer en résonnance avec le champ électromagnétique généré. Cette configuration permet d'établir, selon la sensibilité de la puce et du terminal, une communication entre la puce et le terminal lorsque ceux-ci sont séparés de plusieurs mètres, jusqu'à 10m ou 20m. Une telle puce d'émission-réception « en champ lointain » comprend un circuit de modulation, un circuit de démodulation et un circuit d'alimentation électrique, associés à l'antenne en dipôle et configurés pour rendre la puce d'émission-réception active dans la plage de fonctionnement en fréquence relativement élevée.

Que la puce d'émission-réception soit configurée pour fonctionner en champ proche ou en champ lointain, elle présente généralement une impédance interne essentiellement capacitive de l'ordre du picofarad. C'est notamment le cas des puces d'émission-réception dite « passive » qui tirent leurs énergies du champ capté par l'antenne.

On connaît, par exemple des documents US2012/258660 et US9166276, des puces d'émission-réception permettant de fonctionner en champ proche et en champ lointain. Les dispositifs d'émission-réception formés à partir de ces puces restent donc relativement encombrants et présentent un facteur de forme qui ne permet pas de les intégrer à toute sorte d'objets En outre, le document US 2011/068987 A1 montre des puces d'émission-réception associées qui fonctionnent dans des gammes de fréquences différentes. De plus, le document EP 3 319 168 A1, qui est un document de l'état de l'art selon l'article 54(3) CBE, montre un dispositif d'émission-réception radiofréquence incluant des éléments filaires.

La présente invention vise à pallier tout ou partie des inconvénients précités. Elle vise notamment à fournir un dispositif d'émission-réception apte à fonctionner en champ proche et en champ lointain, qui présente un facteur de forme plus favorable que les solutions de l'état de la technique.

### BREVE DESCRIPTION DE L'INVENTION

En vue de la réalisation de l'un de ces buts, l'objet de l'invention propose un dispositif d'émission-réception radiofréquence selon la revendication 1 comprenant :
- un premier et un deuxième élément filaire conducteur comportant chacun une première extrémité, une seconde extrémité et une partie centrale ;
- une première puce d'émission-réception en champ lointain présentant une première gamme de fréquences de fonctionnement, une première impédance caractéristique, et deux zones de connexion longitudinales de connexion ; un premier segment de chaque élément filaire étant respectivement fixé sur l'une et l'autre des zones de la première puce;
- une deuxième puce d'émission-réception en champ proche présentant une deuxième gamme de fréquences de fonctionnement, inférieure à la première gamme, une deuxième impédance caractéristique, et deux zones longitudinales de connexion; un deuxième segment de chaque élément filaire étant respectivement fixé sur l'une et l'autre des zones de la deuxième puce.

Selon l'invention, le premier et le deuxième élément filaire se combinent à l'impédance caractéristique de la deuxième puce d'émission-réception pour former un dispositif de couplage associé à la première puce d'émission-réception dans la première gamme de fréquences. Ils se combinent également à l'impédance caractéristique de la première puce d'émission-réception pour former un dispositif de couplage associé à la deuxième puce d'émission-réception dans la deuxième gamme de fréquences Toujours selon l'invention, la deuxième puce d'émission-réception, dans la première gamme de fréquences, est passive, son impédance caractéristique est de nature capacitive et elle constitue un court-circuit.

D' autres caractéristiques avantageuses font l'objet des revendications dépendantes:
- la première puce et/ou la deuxième puce est formée d'un substrat comprenant un circuit fonctionnel et d'un capot, l'assemblage du capot et du substrat permettant de constituer les zones longitudinales de connexions sous la forme de rainures longitudinales;
- la première gamme de fréquences de fonctionnement est comprise dans l'une des bandes de fréquence HF, UHF ou VHF, et la deuxième gamme de fréquences de fonctionnement est comprise dans l'une des bandes de fréquences LF, ou MF ;
- la première impédance caractéristique et la deuxième impédance caractéristique présentent une nature capacitive ;
- un segment longitudinal positionné dans la partie centrale du premier élément filaire est fixé sur une zone de connexion de la première puce ;
- un segment longitudinal positionné à une première extrémité du premier élément filaire est fixé sur l'autre zone de connexion de la première puce ;
- un segment longitudinal positionné à une première extrémité du premier élément filaire est fixé sur une zone de connexion de la deuxième puce ;
- un segment longitudinal positionné dans la partie centrale du deuxième élément filaire est fixé sur l'autre zone de connexion de la deuxième puce ;
- le dispositif de couplage associé à la première puce d'émission-réception dans la première gamme de fréquences est une antenne dipôle ;
- le dispositif de couplage associé à la deuxième puce d'émission-réception dans la deuxième gamme de fréquences est constitué de lignes de transmission ;
- le dispositif comprend un composant inductif respectivement connecté au premier élément filaire et au deuxième élément filaire ;
- le dispositif de couplage associé à la deuxième puce d'émission-réception dans la deuxième gamme de fréquences est constitué d'une boucle d'induction magnétique.
- le composant inductif se présente sous la forme d'une puce présentant deux zones longitudinales de connexion sur lesquels sont fixés deux segments du premier et du deuxième élément filaire ;
- le composant inductif est placé du côté de la première puce à l'opposé de la deuxième puce ;
- le composant inductif est intégré à la première puce ;
- l'espace séparant la première et la deuxième puce est empli d'un matériau ferromagnétique.

### BREVE DESCRIPTION DES DESSINS

D'autres caractéristiques et avantages de l'invention ressortiront de la description détaillée de l'invention qui va suivre en référence aux figures annexées sur lesquels :
- La figure 1 représente une vue en perspective d'une puce d'un dispositif compatible avec l'invention ;
- La figure 2 représente une vue en coupe d'une puce d'un dispositif compatible avec l'invention ;
- Les figures 3a à 3c représentent respectivement un dispositif d'émission réception conforme à l'invention, et son état à deux fréquences de fonctionnement différentes.
- Les figures 4a à 4c représentent le principe de fonctionnement d'un premier mode de mise en œuvre de l'invention.
- Les figures 5a à 5c représentent le principe de fonctionnement d'un deuxième mode de mise en œuvre de l'invention.
- Les figures 6 à 8 représentent des variantes de réalisation du deuxième mode de mise en œuvre.

### DESCRIPTION DETAILLEE DE L'INVENTION

Par souci de simplification de la description à venir, les mêmes références sont utilisées pour des éléments identiques ou assurant la même fonction dans l'état de la technique ou dans les différents modes de mise en œuvre exposés du procédé.

La présente invention propose un dispositif d'émission-réception radiofréquence comportant une antenne constituée de deux éléments filaires, et des puces d'émission réception comportant chacune deux zones longitudinales de connexion, parallèles entre elles et sur lesquels deux segments des éléments filaires sont respectivement fixées.

L'invention peut mettre en œuvre la technologie de connexion, particulièrement ingénieuse, désignée par la dénomination commerciale E-THREAD™. Cette technologie est par exemple décrite dans les documents US8093617, US8723312, US2015318409, US8782880, US8814054 ou US2015230336. On rappelle toutefois dans les paragraphes qui suivent, et afin de fournir une description complète, les caractéristiques principales de cette technologie.

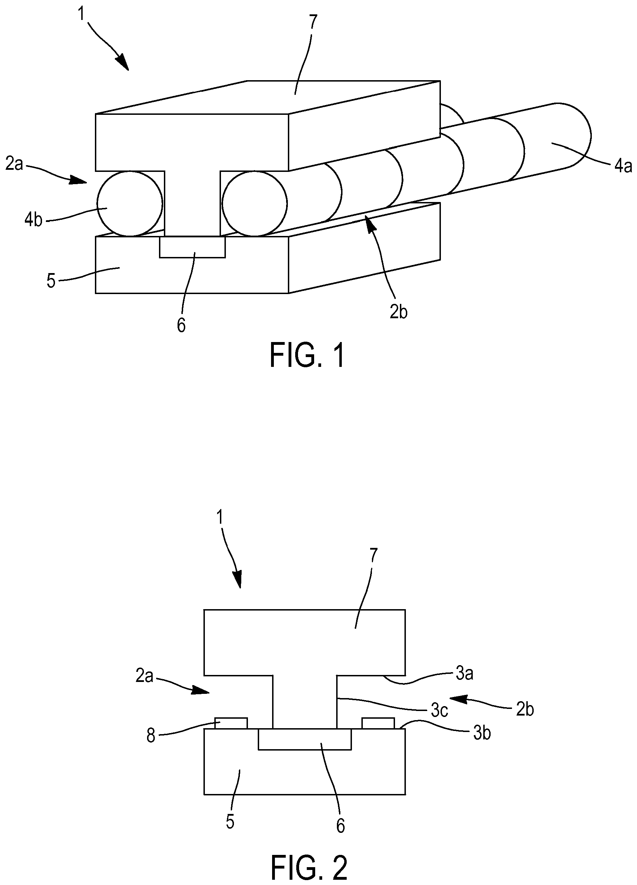

La figure 1 représente ainsi une vue en perspective d'un composant électronique ou d'une puce 1 compatible avec la technologie de connexion E-THREAD™. Sur cette figure 1, la puce 1 est assemblée à deux éléments filaires conducteurs 4a, 4b (et parfois désignés plus simplement « éléments filaires » dans la suite de cette description). La figure 2 représente quant à elle une vue en coupe de la puce 1, sans les éléments filaires 4a, 4b.

La puce 1 comporte deux rainures longitudinales 2a, 2b, formant les deux zones longitudinales de connexion, chacune de ces rainures étant définie par trois parois 3a, 3b, 3c des éléments constituant la puce 1, sur l'exemple représenté. Par « rainure longitudinale » (ou « zone longitudinale ») on désigne dans la présente demande une rainure ou une zone s'étendant d'un coté à l'autre de la puce 1 selon une direction qui définit, de manière arbitraire, la longueur de la puce 1. Chaque rainure 2a, 2b est prévue pour loger un segment d'un élément filaire 4a, 4b. Chaque élément filaire 4a, 4b présente un axe principal, parallèle à l'axe de la rainure longitudinale 2a, 2b dans lequel il est logé.

Chaque élément filaire 4a, 4b peut-être mécaniquement encastré dans une des rainures longitudinales 2a, 2b et/ou maintenu par un adhésif, par soudure ou par tout autre moyen dans cette rainure. Dans tous les cas, les éléments filaires 4a, 4b et la puce sont assemblés l'un à l'autre de manière solidaire.

Comme cela est représenté sur les figures 1 et 2, la puce 1 peut comprendre un substrat 5 sur et dans lequel peut être formé un circuit fonctionnel 6. Une au moins des parois 3a, 3b, 3c de chaque rainure longitudinale 2a, 2b peut être munie d'un plot 8 ou d'une pluralité de tels plots. Lorsque les éléments filaires 4a, 4b sont logés dans leurs rainures 2a, 2b, ils sont en contact avec le ou les plots 8 positionnés dans cette rainure. Ces plots 8 peuvent contribuer à l'encastrement de l'élément filaire dans la rainure. Certains de ces plots 8 peuvent être électriquement reliés à des bornes du circuit fonctionnel 6, et donc former des plots de connexion, par exemple par l'intermédiaire de pistes conductrices formées sur ou dans le substrat 5.

Lorsqu'il y a lieu de former un contact électrique entre un élément filaire 4a, 4b et un plot de connexion 8, il peut être nécessaire de préalablement dénuder l'élément filaire conducteur 4a, 4b, si celui-ci est muni d'une gaine isolante. Alternativement ou en complément, le plot de connexion 8 peut avoir une forme de lame tranchante qui perce la gaine lors de l'insertion du fil afin d'établir le contact électrique.

Poursuivant la description des figures 1 et 2, la puce 1 peut également comprendre un capot 7, par exemple présentant une section en forme de T comme cela est représenté sur la figure 2, assemblé avec une face du substrat 5. L'assemblage du capot 7 en forme de T et du substrat 5 permet de constituer les rainures longitudinales 2a, 2b. Le capot 7 peut également être muni d'un circuit fonctionnel, de plots 8 et de pistes conductrices reliées électriquement au circuit fonctionnel 6 du substrat 5 ou au circuit fonctionnel du capot 7 dans le cas où un tel circuit est présent.

D'autres modes de réalisation de la puce 1 que celui représenté sur les figures 1 et 2 sont possibles. Par exemple, la puce 1 peut être formée d'un support plan comportant le circuit fonctionnel, les rainures longitudinales étant formées, par exemple par gravure, sur deux faces latérales opposées de ce support, ou sur l'une et/ou l'autre des faces principales de ce support.

Dans un mode de réalisation particulier, la puce 1 ne présente pas de rainure. Le capot 7 peut être assemblé au substrat 5 uniquement de manière temporaire, pour temporairement former des rainures et permettre la fixation précise des éléments filaires 2a, 2b sur le substrat 5 au niveau de deux zones longitudinales de connexion, parallèles entre elles. Après cette étape de fixation, le capot 7 peut être désassemblé, et la puce 1 dans ce cas ne comprend pas de capot 7.

Une variante de ce mode de réalisation est décrite dans le document US2015024589 dans lequel le capot 7 est formé par apport d'une matière électriquement isolante sur le substrat 5 après la fixation des éléments filaires 4a, 4b, par exemple au niveau de deux zones longitudinales de connexion 2a, 2b parallèles entre elles.

Selon un autre mode de réalisation, la puce 1 peut être formée de deux supports plans de dimensions identiques ou similaires, comportant l'un et/ou l'autre un circuit fonctionnel. Les supports plans sont assemblés chacun aux deux faces opposées d'une entretoise de plus petite dimension, pour définir les deux rainures longitudinales 2a, 2b de la puce 1.

Quel que soit le mode de réalisation choisi, une puce 1 compatible avec la présente invention comporte un circuit fonctionnel 6, deux zones longitudinales de connexion 2a, 2b aptes à recevoir chacune un segment d'un élément filaire conducteur 4a, 4b. Les éléments filaires conducteurs 4a, 4b sont en contact électrique avec le circuit fonctionnel 6.

La fixation des éléments filaires conducteurs 4a, 4b sur les zones longitudinales 2a, 2b d'une puce 1 peut être automatisée, par exemple à l'aide d'un équipement d'insertion tel que celui décrit dans le document US8782880 ou US2015024589.

Des éléments filaires de grandes dimensions peuvent être fournis dans l'équipement sous la forme de bobines ; et les puces 1, similaires à celle qui vient d'être présentée, stockées dans un réservoir de l'équipement. Les éléments filaires de grande dimension sont dévidés des bobines pour être amenés, parallèles l'un à l'autre, au niveau d'une zone de pincement de l'équipement. Celui-ci est également configuré pour amener successivement des puces 1 issues du réservoir au niveau de cette zone de pincement et pour engager un segment de chaque élément filaire de grande dimension dans l'une et l'autre des rainures longitudinales 2a, 2b, ou plus généralement fixer chaque élément filaire 4a, 4b sur les zones longitudinales de connexion 2a, 2b. On forme de la sorte une chaîne composée d'une pluralité de puces 1 reliées par les éléments filaires de grandes dimensions. L'équipement peut être muni d'une pluralité de réservoirs pour y stocker des puces de natures différentes et former une chaîne de puces composites selon une alternance qui peut être choisie. La chaîne de puces peut être enroulée sur un support pour former une bobine, en vue de son stockage et son transport. Des éléments fonctionnels, c'est-à-dire des tronçons de cette chaîne, peuvent être prélevés de la bobine, en découpant les éléments filaires 4a, 4b suivant un motif désiré de découpe, comme cela est décrit dans le document US8471773 précité.

La présente invention met à profit les caractéristiques générales de la technologie qui vient d'être présentée, pour proposer un dispositif d'émission réception radiofréquence 10 pouvant fonctionner à la fois en champ lointain et en champ proche.

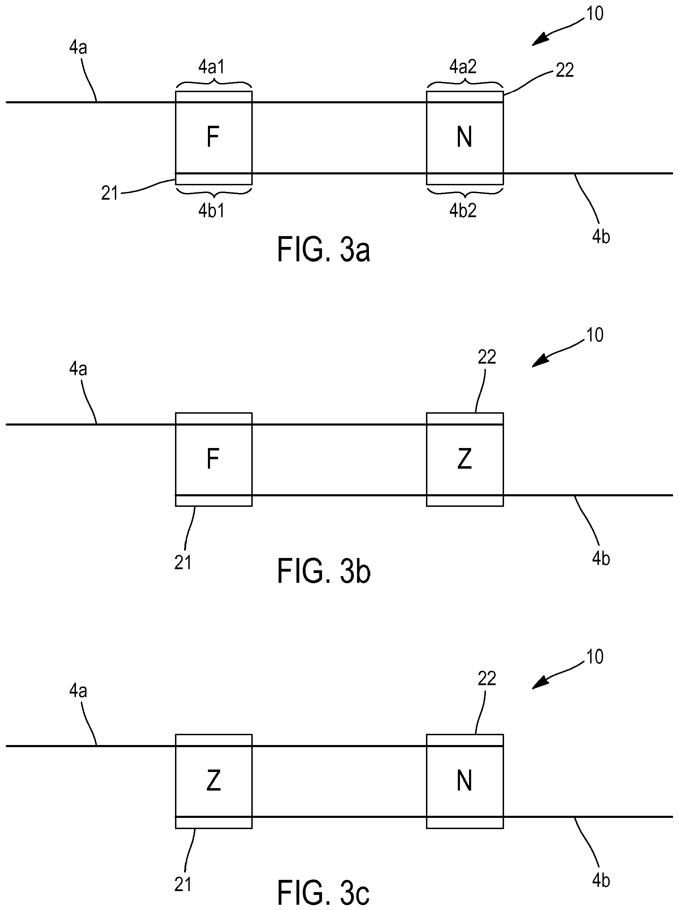

Un tel dispositif 10 est représenté sur la figure 3a. Il comprend un premier et un deuxième élément filaire conducteur 4a, 4b. Chacun de ces éléments filaires comprend une première extrémité, une deuxième extrémité, et une partie centrale. Le dispositif 10 comprend également une première puce d'émission réception en champ lointain 21 fonctionnant dans une première gamme de fréquences. Il peut s'agir d'une puce RFID passive ou active, fonctionnant dans les bandes de fréquences à HF, VHF ou UHF. La première puce 21 dispose donc d'un circuit fonctionnel 6 comprenant un circuit de modulation et un circuit de démodulation conçus pour fonctionner dans une gamme de fréquences comprise dans l'une de ces bandes de fréquences. La première puce 21 peut transmettre à une distance relativement importante, plusieurs mètres ou dizaines de mètres, différentes données telles que son identifiant unique, ses données d'état, des données de télémétrie telle que la température ou l'humidité, si la première puce 21 est munie de capteurs permettant la mesure de ces informations.

La première puce 21 présente deux zones longitudinales de connexion sur lesquelles deux segments longitudinaux 4a1, 4b1 des éléments filaires 4a, 4b sont respectivement fixés. Les zones sont munies de plots de connexion permettant de mettre en contact électrique chaque élément filaire 4a, 4b avec le dispositif fonctionnel 6 de la première puce en champ lointain 21.

La première puce 21 présente, entre ses plots de connexion, une première impédance caractéristique. Cette impédance caractéristique peut dépendre de la fréquence, mais habituellement elle est de nature capacitive et présente typiquement une valeur de quelques picofarads.

Poursuivant la description de la figure 3a, le dispositif d'émission-réception radiofréquence 10 comprend également une deuxième puce d'émission-réception en champ proche 22, fonctionnant dans une deuxième gamme de fréquences. Cette deuxième gamme de fréquences de fonctionnement est inférieure à la première gamme de fréquences de fonctionnement de la première puce 21. Il peut ainsi s'agir d'une puce NFC fonctionnement dans une bande de fréquences LF ou MF. La deuxième puce 22 dispose donc d'un circuit fonctionnel comprenant un circuit de modulation et de modulation configurés pour fonctionner dans l'une de ces bandes de fréquences. Cette deuxième puce 22, en champ proche, peut communiquer avec un terminal de lecture lorsque celui-ci est disposé à une distance courte, de quelques millimètres à 1 m. La nature des informations échangées, tout comme pour la première puce 21, est quelconque et peut comprendre l'identifiant unique de la deuxième puce 22 ou tout autre type d'information.

Similairement à la première puce 21, la deuxième puce 22 présentes deux zones longitudinales de connexion sur lesquelles les deux éléments filaires 4a, 4b sont respectivement fixés, au niveau de segments longitudinaux 4a2, 4b2. Les zones de la deuxième puce 22 sont munies de plots de connexion mettant en contact électrique chaque élément filaire avec le dispositif fonctionnel de cette deuxième puce 22. Elle présente aussi, entre ses plots, une deuxième impédance caractéristique qui peut dépendre de la fréquence et qui est également habituellement de nature capacitive, de quelques picofarads.

Dans la configuration représentée sur les figures 3a à 3c, un segment longitudinal 4a1 du premier élément filaire 4a, positionné dans une partie centrale de cet élément, est fixé sur une zone de connexion de la première puce 21. Un autre segment longitudinal 4a2 du premier élément filaire 4a, positionné à la première extrémité de cet élément 4a, est fixé dans l'une des zones de connexion de la deuxième puce 22. Similairement, un autre segment longitudinal 4b2 du deuxième élément filaire 4b, positionné dans la partie centrale de cet élément, est fixé dans une zone de connexion de la deuxième puce 22. Un autre segment 4b1 du deuxième élément filaire 4b, positionné à une extrémité de cet élément, est fixé sur l'autre zone de connexion de la première puce 21. Comme on l'a vu précédemment, les zones de connexion peut se présenter sous la forme de rainures, et dans ce cas les différents segments longitudinaux précités 4a1, 4a2, 4b1, 4b2 sont respectivement logés dans ces rainures.

La figure 3b représente schématiquement le dispositif d'émission-réception 10 lorsqu'il est soumis à un champ électromagnétique à haute fréquence, par exemple présentant une fréquence dans l'une des bandes HF, UHF, VHF, et comprise dans la gamme de fréquences de fonctionnement de la première puce 21.

Dans cet état, la première puce 21 d'émission réception est susceptible de fonctionner, c'est-à-dire que si un dispositif de couplage, tel qu'une antenne dipôle, est connecté électriquement aux bornes de connexion de la première puce 21, celle-ci est apte à démoduler le signal fourni, à effectuer des traitements et, en retour, moduler des informations à transmettre par l'intermédiaire du dispositif de couplage.

La deuxième puce 22 quant à elle n'est pas susceptible de fonctionner à cette fréquence. C'est-à-dire que son comportement est purement passif et qu'elle constitue, vu de ses bornes de connexion, une pure impédance dont la valeur correspond à son impédance caractéristique à cette fréquence.

La figure 3c représente schématiquement le dispositif d'émission-réception 10 lorsqu'il est soumis à un champ électromagnétique à basse fréquence, par exemple présentant une fréquence dans l'une des bandes LF ou MF, et comprise dans la gamme de fréquences de fonctionnement de la deuxième puce 22.

Dans cet état, et à l'opposé de ce qui a été présenté en relation avec la figure 3b, la première puce en champ lointain 21 n'est pas susceptible de fonctionner et se comporte comme une pure impédance dont la valeur correspond à son impédance caractéristique à cette fréquence. La deuxième puce en champ proche 22, quant à elle, est apte à démoduler un signal qui lui serait fourni par un dispositif de couplage connecté électriquement à ses bornes, effectuer des traitements, et moduler des informations à transmettre par l'intermédiaire du dispositif de couplage.

La présente invention met à profit ces observations pour que, dans la première gamme de fréquences, le premier élément filaire 4a et le deuxième élément filaire 4b se combinent électriquement à l'impédance caractéristique de la deuxième puce d'émission-réception 22 pour former un dispositif de couplage associé à la première puce d'émission réception 21.

En d'autres termes, la deuxième puce 22, qui est passive dans la première gamme de fréquences, ce combine électriquement avec les éléments filaires 4a, 4b pour former l'antenne connectée à la première puce 21 permettant au dispositif d'émission réception 10 d'être pleinement fonctionnel dans cette première gamme de fréquences.

Dans la deuxième gamme de fréquences, le premier et le deuxième élément filaire 4a, 4b se combinent électriquement à l'impédance caractéristique de la première puce 21 pour former un dispositif de couplage associé à la deuxième puce 22. En d'autres termes, la première puce 21, qui est passive dans la deuxième gamme de fréquences, se combine électriquement avec les éléments filaires 4a, 4b pour former l'antenne connectée à la deuxième puce 22 permettant au dispositif d'émission-réception 10 d'être également pleinement fonctionnel dans cette deuxième gamme de fréquences.

### Premier mode de réalisation

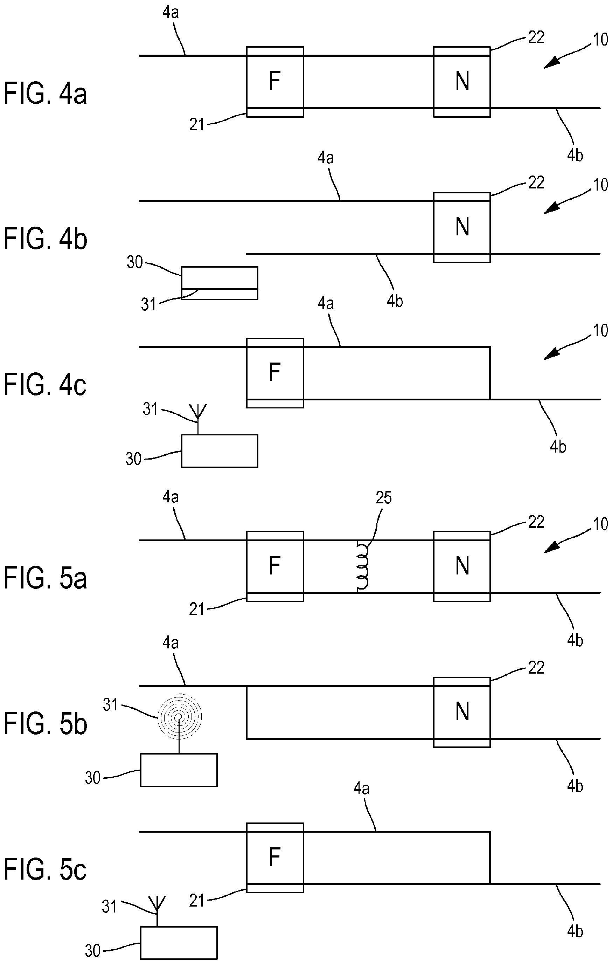

La figure 4a représente le dispositif d'émission-réception 10 conforme à un premier mode de réalisation de l'invention. Le dispositif est configuré de manière tout à fait similaire à ce qui a été présenté dans la description générale.

Sur la figure 4b, on a représenté le schéma électrique équivalent du dispositif 10 de la figure 4a, à la fréquence de fonctionnement de la deuxième puce en champ proche 22. À cette fréquence de fonctionnement, la première puce en champ lointain 21 est passive, et son impédance caractéristique étant de nature capacitive, elle constitue à la fréquence de fonctionnement de la deuxième puce, un circuit ouvert. Dans cette configuration, les éléments filaires 4a, 4b connectés électriquement aux bornes de connexion de la deuxième puce en champ proche 22 forment des lignes de transmission.

Ces lignes de transmission constituent le dispositif de couplage de la deuxième puce en champ proche 22, apte à transmettre et recevoir un signal électrique radiofréquence à une autre ligne de transmission 31 d'un terminal d'émission réception 30 disposés à proximité du dispositif 10. Préférablement, pour améliorer la qualité de la transmission, la ligne de transmission 31 du terminal est disposée parallèlement à la ligne de transmission constituée par l'un des éléments filaires 4a, 4b. On pourra également facilement adapter l'impédance du dispositif de couplage en forme de lignes de transmission, en ajustant la longueur des éléments filaires et/ou en ajustant la distance séparant ces deux éléments filaires, i.e. la distance séparant, au niveau des puces d'émission-réceptions 21,22, les zones de connexion sur lesquels sont fixées les éléments filaires.

Sur la figure 4c, on a représenté le schéma électrique équivalent du dispositif 10 de la figure 4a à la fréquence de fonctionnement de la première puce 21 en champ lointain, comprise donc dans la première gamme de fréquences de fonctionnement.

À cette fréquence de fonctionnement, la deuxième puce 22 est passive et son impédance caractéristique étant de nature capacitive, elle constitue à cette fréquence un court-circuit.

Dans cette configuration, les deux éléments filaires 4a, 4b connectés électriquement aux bornes de connexions de la première puce en champ lointain 21 forment une antenne dipôle. À cet effet, la longueur de chaque élément filaire est choisie pour correspondre au quart de la longueur de l'onde se propageant, comme cela est bien connu en soi. Le court-circuit que constitue la deuxième puce en champ proche 22 à la fréquence de fonctionnement de la première puce permet de constituer une boucle d'adaptation de l'impédance de l'antenne. On pourra cet effet choisir la distance séparant les puces 21 et 22 pour que cette boucle présente effectivement la dimension requise pour permettre cette adaptation.

Le dispositif de couplage ainsi constitué en dipôle est apte à transmettre et recevoir un signal électromagnétique radiofréquence à la fréquence de fonctionnement de la première puce. Il peut communiquer avec un terminal d'émission-réception 30 muni d'une antenne compatible 31. Cette transmission peut se réaliser à grande distance, de plusieurs mètres, entre le dispositif d'émission réception 10 et le terminal 30.

### Deuxième mode de réalisation

La figure 5a représente un dispositif d'émission-réception 10 conforme à un deuxième mode de réalisation de l'invention. Ce deuxième mode de réalisation diffère du premier mode en ce que l'on a ajouté un composant inductif 25 entre le premier élément filaire 4a et le deuxième élément filaire 4b. Ce composant inductif 25 est placé à proximité ou au niveau des segments 4a1, 4b1 des éléments filaires qui sont fixés sur les zones de connexion de la première puce en champ lointain 21.

On a représenté sur la figure 5b le schéma électrique équivalent du dispositif 10 de la figure 5a à la fréquence de fonctionnement de la deuxième puce en champ proche 22, et donc comprise dans la deuxième gamme de fréquences de fonctionnement. À cette fréquence de fonctionnement, l'élément inductif 25, en parallèle avec l'impédance caractéristique capacitive de la première puce, 21 forme un court-circuit.

On note donc qu'à la fréquence de fonctionnement de la deuxième puce 22, les éléments filaires 4a, 4b se combinent avec l'impédance caractéristique de la première puce et à l'élément inductif 25 pour constituer un dispositif de couplage en boucle. La disposition de ce dispositif de couplage est apte à transmettre et recevoir, par induction magnétique, un signal magnétique radiofréquence à la fréquence de fonctionnement de la deuxième puce 22 et communiquer avec un terminal d'émission réception 30 muni de son propre dispositif de couplage 31.

La figure 5c représente le schéma électrique équivalent du dispositif d'émission-réception 10 de ce deuxième mode de réalisation à la fréquence de fonctionnement de la première puce 21. L'élément inductif 25, à cette fréquence relativement élevée de fonctionnement, forme un circuit ouvert. La configuration représentée sur la figure 5c est identique à celle du premier mode de réalisation représentée sur la figure 4c. Les mêmes commentaires s'appliquent donc et ne sont pas reproduits par souci de concision.

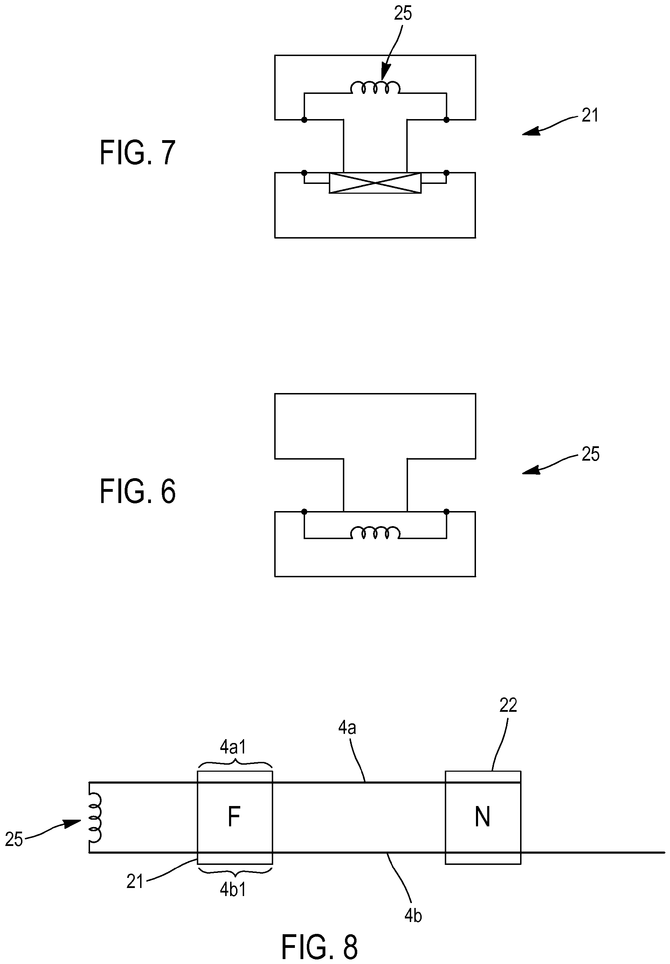

Avantageusement, et comme cela est représenté sur la figure 6, l'élément inductif 25 se présente sous la forme d'une puce compatible avec la technologie E-THREAD. A cet effet, la puce est munie de deux rainures longitudinales dans lesquelles sont déposés des plots de connexion pour relier électriquement des éléments filaires au dispositif fonctionnel constitué d'une inductance. Plus généralement, l'élément inductif 25 peut se présenter sous la forme d'une puce présentant deux zones de connexion, parallèles entre elles.

Dans une variante de ce deuxième mode de réalisation particulièrement avantageux, l'élément inductif 25 est intégré à la première puce 21. On évite ainsi de devoir fixer séparément l'élément inductif 25 entre les éléments filaires 4a et 4b. Cette variante peut être mise en œuvre à l'aide d'une première puce 21 intégrant par exemple dans un capot 7 le dispositif inductif 25 comme cela est représenté sur la figure 7.

Afin de favoriser le couplage électromagnétique, on peut prévoir d'emplir l'espace séparant les deux puces 21, 22 et constituant une partie au moins du dispositif de couplage, d'un matériau ferromagnétique.

La figure 8 se représente une variante de mise en œuvre du deuxième mode de réalisation. Dans cette variante, la première puce 21 est associée aux éléments filaires 4a, 4b au niveau de segments longitudinaux 4a1, 4b1 placés dans les parties centrales des éléments filaires 4a, 4b. Les éléments filaires 4a, 4b présentent donc chacun des extrémités situées de part et d'autre de la première puce 21. L'élément inductif 25 qui peut être réalisé sous la forme d'une puce à zones de connexion, telle que les rainures représentées sur la figure 6, peut donc être placé du côté de la première puce 21 à l'opposé de la deuxième puce 22. De la sorte, le dispositif de couplage en boucle peut présenter une dimension plus importante que celle que l'on peut obtenir avec la configuration de la figure 5a. Une boucle plus importante favorise le couplage magnétique avec le terminal 30. On peut bien entendu combiner cette variante avec la présence d'un corps ou d'une substance ferromagnétique à l'intérieur de la boucle, comme cela a été exposé précédemment.

Quel que soit le mode de mise en œuvre choisi et les variantes employées, le dispositif d'émission réception 10 conforme à l'invention présente la caractéristique de pouvoir fonctionner en champ proche et en champ lointain. Il emploie des composants, notamment les puces d'émission réception 21, 22 tout à fait standard, et donc disponible à faible coût. Elle présente un facteur de forme tout à fait avantageux, et pas significativement plus encombrant qu'un dispositif d'émission réception fonctionnant uniquement selon l'un des modes d'émission réception en champ proche ou lointain.

Bien entendu l'invention n'est pas limitée aux modes de mise en œuvre décrits et on peut y apporter des variantes de réalisation sans sortir du cadre de l'invention tel que défini par les revendications.

Ainsi, bien que l'on ait ici choisi dans les différents modes de réalisation exposés, le cas de puces d'émission-réception présentant une impédance de nature capacitive, on peut envisager de mettre en œuvre des puces d'émission-réception présentant une impédance ayant une autre nature. On pourra s'adapter facilement à cette situation en prévoyant de placer entre les deux éléments filaires des composants d'adaptation, similaire au composant inductif 25, permettant d'aboutir aux schémas électriques équivalents recherchés en haute et basse fréquence. On pourra également, comme cela est bien connu de l'homme du métier, ajuster le longueur, l'écartement, la terminaison des éléments filaires pour adapter l'impédance du dispositif de couplage selon la nature de l'impédance caractéristique de la première puce 21 et/ou de la deuxième puce 22.

Par ailleurs, il n'est pas nécessaire que les deux fonctionnalités « en champ proche » et « en champ lointain » du dispositif d'émission réception soit exploitées. On peut envisager de fournir des dispositifs génériques, pour lesquels un utilisateur pourrait choisir d'exploiter uniquement l'une des deux fonctionnalités.

## Revendications

1. Dispositif d'émission-réception radiofréquence (10) comprenant
- un premier et un deuxième élément filaire conducteur (4a, 4b) comportant chacun une première extrémité, une seconde extrémité et une partie centrale ;
- une première puce d'émission-réception en champ lointain (21) présentant une première gamme de fréquences de fonctionnement, une première impédance caractéristique, et deux zones longitudinales de connexion ; un premier segment (4a1, 4b1) de chaque élément filaire étant respectivement fixé sur l'une et l'autre des zones longitudinales de connexion de la première puce (21);
- une deuxième puce d'émission-réception en champ proche (22) présentant une deuxième gamme de fréquences de fonctionnement, inférieure à la première gamme, une deuxième impédance caractéristique, et deux zones longitudinales de connexion; un deuxième segment (4a2, 4b2) de chaque élément filaire étant respectivement fixé sur l'une et l'autre des zones de la deuxième puce (22) ;
le premier et le deuxième élément filaire (4a, 4b) se combinant à l'impédance caractéristique de la deuxième puce d'émission-réception (22) pour former un dispositif de couplage associé à la première puce d'émission-réception (21) dans la première gamme de fréquences, la deuxième puce d'émission-réception (22), dans cette première gamme de fréquences , étant passive, son impédance caractéristique étant de nature capacitive, et constituant un court-circuit ; et se combinant à l'impédance caractéristique de la première puce d'émission-réception (21) pour former un dispositif de couplage associé à la deuxième puce d'émission-réception (22) dans la deuxième gamme de fréquences.

2. Dispositif (10) selon la revendication précédente dans lequel la première puce et/ou la deuxième puce (21,22) est formée d'un substrat (5) comprenant un circuit fonctionnel (6) et d'un capot (7), l'assemblage du capot (7) et du substrat (5) permettant de constituer les zones longitudinales de connexions sous la forme de rainures longitudinales.

3. Dispositif (10) selon l'une des revendications précédentes dans lequel la première gamme de fréquences de fonctionnement est comprise dans l'une des bandes de fréquence HF, UHF ou VHF, et la deuxième gamme de fréquences de fonctionnement est comprise dans l'une des bandes de fréquences LF, ou MF.

4. Dispositif (10) selon l'une des revendications précédentes dans lequel l'impédance caractéristique de la première et de la deuxième Z puce présente une nature capacitive.

5. Dispositif (10) selon l'une des revendications précédentes dans lequel :
- un segment longitudinal (4a1) positionné dans la partie centrale du premier élément filaire (4a) est fixé sur une zone de connexion de la première puce (21) ;
- un segment longitudinal (4b1) positionné à une première extrémité du deuxième élément filaire (4b) est fixé sur l'autre zone de connexion de la première puce (21) ;
- un segment longitudinal (4a2) positionné à une première extrémité du premier élément filaire (4a) est fixé sur une zone de connexion de la deuxième puce (22) ;
- un segment longitudinal (4b2) positionné dans la partie centrale du deuxième élément filaire (4b) est fixé sur l'autre zone de connexion de la deuxième puce (22) ;

6. Dispositif (10) selon la revendication précédente dans lequel le dispositif de couplage associé à la première puce d'émission-réception (21) dans la première gamme de fréquences est une antenne dipôle.

7. Dispositif (10) selon l'une des deux revendications précédentes dans lequel le dispositif de couplage associé à la deuxième puce d'émission-réception (22) dans la deuxième gamme de fréquences est constitué de lignes de transmission.

8. Dispositif (10) selon l'une des revendication 1 à 6 comprenant un composant inductif (25) respectivement connecté au premier élément filaire (4a) et au deuxième élément filaire (4b).

9. Dispositif (10) selon la revendication précédente dans lequel le dispositif de couplage associé à la deuxième puce d'émission-réception (22) dans la deuxième gamme de fréquences est constitué d'une boucle d'induction magnétique.

10. Dispositif (10) selon l'une des deux revendications précédentes 8 et 9 dans lequel le composant inductif (25) se présente sous la forme d'une puce présentant deux zones longitudinales de connexion sur lesquels sont fixés deux segments du premier et du deuxième élément filaire (4a, 4b).

11. Dispositif (10) selon la revendication précédente dans lequel le composant inductif (25) est placé du côté de la première puce (21) à l'opposé de la deuxième puce (22).

12. Dispositif (10) selon la revendication 10 dans lequel le composant inductif (25) est intégré à la première puce.

13. Dispositif (10) selon l'une des revendications précédentes dans lequel l'espace séparant la première et la deuxième puce est empli d'un matériau ferromagnétique.

## Patentansprüche

1. Hochfrequenz-Transceiver-Vorrichtung (10), umfassend
- ein erstes und ein zweites leitendes Drahtelement (4a, 4b), die jeweils ein erstes Ende, ein zweites Ende und einen mittleren Abschnitt aufweisen;
- einen ersten Fernfeld-Transceiver-Chip (21) mit einem ersten Betriebsfrequenzbereich, einer ersten charakteristischen Impedanz und zwei Längsverbindungsbereichen; wobei ein erstes Segment (4a1, 4b1) jedes Drahtelements jeweils an dem einen und dem anderen der Längsverbindungsbereiche des ersten Chips (21) angebracht ist;
- einen zweiten Nahfeld-Transceiver-Chip (22) mit einem zweiten Betriebsfrequenzbereich, der niedriger als der erste Bereich ist, einer zweiten charakteristischen Impedanz und zwei Längsverbindungsbereichen; wobei ein zweites Segment (4a2, 4b2) jedes Drahtelements jeweils an dem einen und dem anderen der Bereiche des zweiten Chips (22) angebracht ist;
wobei das erste und das zweite Drahtelement (4a, 4b) mit der charakteristischen Impedanz des zweiten Transceiver-Chips (22) kombiniert werden, um eine Kopplungsvorrichtung zu bilden, die dem ersten Transceiver-Chip (21) im ersten Frequenzbereich zugeordnet ist, wobei der zweite Transceiver-Chip (22) in diesem ersten Frequenzbereich passiv ist, seine charakteristische Impedanz kapazitiver Natur ist und einen Kurzschluss darstellt; und
mit der charakteristischen Impedanz des ersten Transceiver-Chips (21) kombiniert wird, um eine Kopplungsvorrichtung zu bilden, die dem zweiten Transceiver-Chip (22) im zweiten Frequenzbereich zugeordnet ist.

2. Vorrichtung (10) nach dem vorhergehenden Anspruch, wobei der erste Chip und/oder der zweite Chip (21, 22) aus einem Substrat (5), umfassend eine funktionelle Schaltung (6), und einer Abdeckung (7) gebildet ist, wobei der Zusammenbau der Abdeckung (7) und des Substrats (5) es ermöglicht, die Längsverbindungsbereiche in Form von Längsrillen zu bilden.

3. Vorrichtung (10) nach einem der vorhergehenden Ansprüche, wobei der erste Betriebsfrequenzbereich in einem der HF-, UHF- oder VHF-Frequenzbänder liegt und der zweite Betriebsfrequenzbereich in einem der LF- oder MF-Frequenzbänder liegt.

4. Vorrichtung (10) nach einem der vorhergehenden Ansprüche, wobei die charakteristische Impedanz des ersten und zweiten Chips kapazitiver Natur ist.

5. Vorrichtung (10) nach einem der vorhergehenden Ansprüche, wobei:
- ein Längssegment (4a1), das im mittleren Abschnitt des ersten Drahtelements (4a) positioniert ist, an einem Verbindungsbereich des ersten Chips (21) angebracht ist;
- ein Längssegment (4b1), das an einem ersten Ende des zweiten Drahtelements (4b) positioniert ist, an dem anderen Verbindungsbereich des ersten Chips (21) angebracht ist;
- ein Längssegment (4a2), das an einem ersten Ende des ersten Drahtelements (4a) positioniert ist, an einem Verbindungsbereich des zweiten Chips (22) angebracht ist;
- ein Längssegment (4b2), das im mittleren Abschnitt des zweiten Drahtelements (4b) positioniert ist, an dem anderen Verbindungsbereich des zweiten Chips (22) angebracht ist;

6. Vorrichtung (10) nach dem vorhergehenden Anspruch, wobei die dem ersten Transceiver-Chip (21) zugeordnete Kopplungsvorrichtung in dem ersten Frequenzbereich eine Dipolantenne ist.

7. Vorrichtung (10) nach einem der beiden vorhergehenden Ansprüche, wobei die dem zweiten Transceiver-Chip (22) zugeordnete Kopplungsvorrichtung im zweiten Frequenzbereich aus Übertragungsleitungen besteht.

8. Vorrichtung (10) nach einem der Ansprüche 1 bis 6, umfassend ein induktives Bauteil (25), das jeweils mit dem ersten Drahtelement (4a) und dem zweiten Drahtelement (4b) verbunden ist.

9. Vorrichtung (10) nach dem vorhergehenden Anspruch, wobei die dem zweiten Transceiver-Chip (22) zugeordnete Kopplungsvorrichtung im zweiten Frequenzbereich aus einer magnetischen Induktionsschleife besteht.

10. Vorrichtung (10) nach einem der beiden vorhergehenden Ansprüche 8 und 9, wobei das induktive Bauteil (25) die Form eines Chips mit zwei Längsverbindungsbereichen hat, an denen zwei Segmente des ersten und zweiten Drahtelements (4a, 4b) angebracht sind.

11. Vorrichtung (10) nach dem vorhergehenden Anspruch, wobei das induktive Bauteil (25) auf der dem zweiten Chip (22) gegenüberliegenden Seite des ersten Chips (21) angeordnet ist.

12. Vorrichtung (10) nach Anspruch 10, wobei das induktive Bauteil (25) auf dem ersten Chip integriert ist.

13. Vorrichtung (10) nach einem der vorhergehenden Ansprüche, wobei der Raum, der den ersten und den zweiten Chip voneinander trennt, mit einem ferromagnetischen Material gefüllt ist.

## Claims

1. Radiofrequency transceiver device (10), comprising
- a first and a second conductive wire element (4a, 4b), each including a first end, a second end and a central part;
- a first, far-field transceiver chip (21) having a first operating frequency range, a first characteristic impedance, and two longitudinal connection regions; a first segment (4a1, 4b1) of each wire element being secured to one and the other, respectively, of the longitudinal connection regions of the first chip (21);
- a second, near-field transceiver chip (22) having a second operating frequency range that is smaller than the first range, a second characteristic impedance, and two longitudinal connection regions; a second segment (4a2, 4b2) of each wire element being secured to one and the other, respectively, of the regions of the second chip (22);
the first and second wire elements (4a, 4b) combining at the characteristic impedance of the second transceiver chip (22) to form a coupling device associated with the first transceiver chip (21) in the first frequency range, the second transceiver chip (22), in this first frequency range, being passive, its characteristic impedance being capacitive in nature, and constituting a short circuit; and
combining at the characteristic impedance of the first transceiver chip (21) to form a coupling device associated with the second transceiver chip (22) in the second frequency range.

2. Device (10) according to the preceding claim, wherein the first chip and/or the second chip (21, 22) is formed by a substrate (5) comprising a functional circuit (6) and a cover (7), it being possible, by joining the cover (7) and the substrate (5), for the longitudinal connection regions to be created in the form of longitudinal grooves.

3. Device (10) according to either of the preceding claims, wherein the first operating frequency range is within one of the HF, UHF or VHF frequency bands, and the second operating frequency range is within one of the LF or MF frequency bands.

4. Device (10) according to any of the preceding claims, wherein the characteristic impedance of the first and of the second chip is capacitive in nature.

5. Device (10) according to any of the preceding claims, wherein:
- a longitudinal segment (4a1) positioned in the central part of the first wire element (4a) is secured on one connection region of the first chip (21);
- a longitudinal segment (4b1) positioned at a first end of the second wire element (4b) is secured on the other connection region of the first chip (21);
- a longitudinal segment (4a2) positioned at a first end of the first wire element (4a) is secured on one connection region of the second chip (22);
- a longitudinal segment (4b2) positioned in the central part of the second wire element (4b) is secured on the other connection region of the second chip (22).

6. Device (10) according to the preceding claim, wherein the coupling device associated with the first transceiver chip (21) in the first frequency range is a dipole antenna.

7. Device (10) according to either of the two preceding claims, wherein the coupling device associated with the second transceiver chip (22) in the second frequency range consists of transmission lines.

8. Device (10) according to any of claims 1 to 6, comprising an inductive component (25) connected to the first wire element (4a) and to the second wire element (4b).

9. Device (10) according to the preceding claim, wherein the coupling device associated with the second transceiver chip (22) in the second frequency range consists of a magnetic induction loop.

10. Device (10) according to either of the two preceding claims 8 and 9, wherein the inductive component (25) is in the form of a chip having two longitudinal connection regions on which two segments of the first and of the second wire element (4a, 4b) are secured.

11. Device (10) according to the preceding claim, wherein the inductive component (25) is placed on the first chip (21) side, opposite the second chip (22).

12. Device (10) according to claim 10, wherein the inductive component (25) is integrated in the first chip.

13. Device (10) according to any of the preceding claims, wherein the space separating the first and the second chip is filled with a ferromagnetic material.
